(19) **Europäisches Patentamt / European Patent Office / Office européen des brevets**

(11) **EP 2 803 959 B1**

(12) **EUROPÄISCHE PATENTSCHRIFT**

(45) Veröffentlichungstag und Bekanntmachung des Hinweises auf die Patenterteilung:
**12.01.2022   Patentblatt 2022/02**

(21) Anmeldenummer: **14167350.9**

(22) Anmeldetag: **07.05.2014**

(51) Int Cl.:
*G01J 1/04* (2006.01)   *G01J 1/42* (2006.01)
*G01J 3/50* (2006.01)   *H01L 31/0216* (2014.01)
*H01L 27/144* (2006.01)

(54) **Sensoranordnung mit einem siliziumbasierten optischen Sensor und einem Substrat für funktionelle Schichtsysteme**

Sensor assembly with a silicon-based optical sensor and a substrate for functional layer systems

Système de capteur doté d'un capteur optique à base de silicium et d'un substrat pour des systèmes de couches fonctionnelles

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.05.2013   DE 102013104968**

(43) Veröffentlichungstag der Anmeldung:
**19.11.2014   Patentblatt 2014/47**

(73) Patentinhaber: **ams Sensors Germany GmbH
07745 Jena (DE)**

(72) Erfinder:
• **Sieß, Gunter
  07986 Kraftsdorf (DE)**

• **Röppischer, Dr. Marcus
  07338 Kaulsdorf (DE)**
• **Krüger, Dr. Wilfried
  99099 Erfurt (DE)**

(74) Vertreter: **Iqbal, Md Mash-Hud
Marks & Clerk LLP
62-68 Hills Road
Cambridge CB2 1LA (GB)**

(56) Entgegenhaltungen:
**EP-A2- 2 009 696      JP-A- H05 316 284
US-A1- 2008 278 665   US-A1- 2010 026 866
US-B1- 7 626 241      US-B2- 7 330 266**

EP 2 803 959 B1

**Beschreibung**

Die Erfindung betrifft eine Sensoranordnung mit einem siliziumbasierten optischen Sensor, insbesondere für Tageslichtsensoren oder Farbsensoren für kolorimetrische Anwendungen.

Die Verbindung von optischen Sensoren mit funktionalen Gläsern (vorzugsweise Substraten mit Interferenzfiltern, die nicht direkt auf den Sensor beschichtet werden können) führt zu zwei unerwünschten additiv überlagerten Interferenzrippeln einerseits in der Passivierungsschicht des lichtempfindlichen Sensorabschnitts und andererseits in der Zwischenschicht (Luft oder Klebstoff) zum funktionalen Deckglas. Jede für sich beeinflusst die aus Basisempfindlichkeit des Sensors und der Transmissionseigenschaft des aufgesetzten Substrats resultierende spektrale Empfindlichkeit. Die Größe der Interferenzrippel wird beeinflusst durch die Brechungsindizes und die Dicken der Schichten.

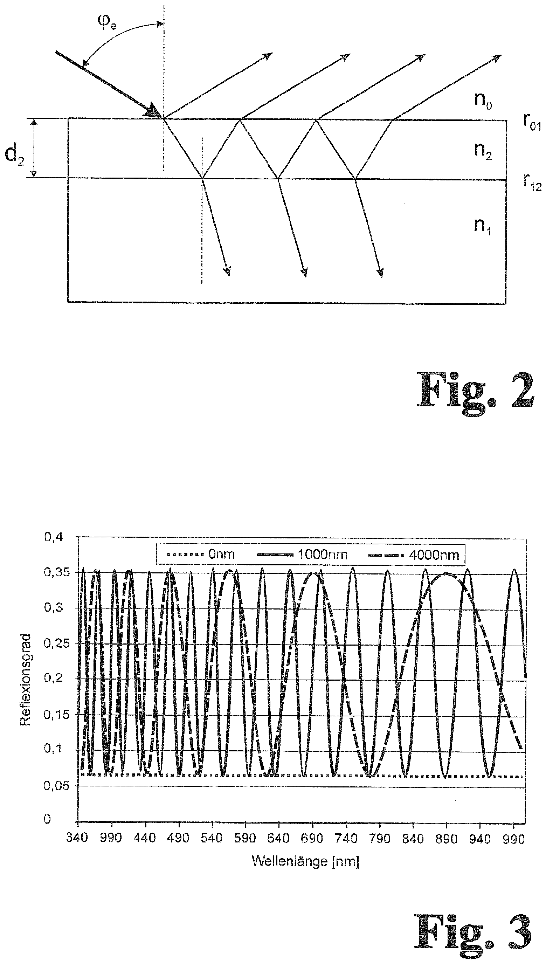

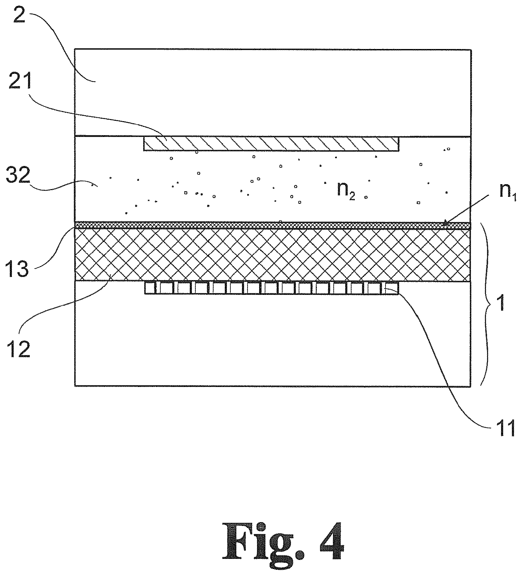

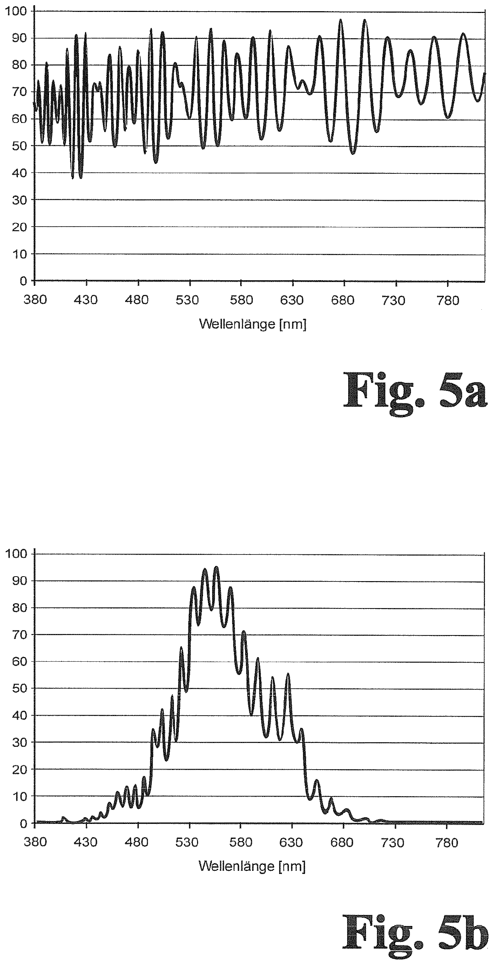

Besonders für optische Sensoren, die definierte Transmissionseigenschaften voraussetzen (wie z.B. für Tageslichtsensoren oder Farbsensoren für kolorimetrische Anwendungen), ist eine Minimierung dieser Effekte entscheidend für die Einsatzgebiete des Sensors. Fig. 5b zeigt die resultierende spektrale Empfindlichkeit eines Sensors mit Y-Normspektralwertfunktion ohne geeignete Maßnahmen zur Unterdrückung der Interferenzrippel. Den zugehörigen Sensor, der zwar so nicht vorbeschrieben, aber aus bekannten Schichtsystemen einfach mittels eines optischen Klebstoffs zusammensetzbar ist, zeigt Fig. 4. Durch das Aufbringen eines Interferenzfilters auf den Sensor (z.B. eine Siliziumdiode) kommt es zu starken Schichtinterferenzen innerhalb der Klebeschicht. Grund dafür ist der hohe Unterschied des Brechungsindex der Klebeschicht gegenüber der Si-Oberfläche des Sensors bzw. dessen ebenfalls siliziumhaltigen Passivierungsschichten und gegenüber dem Brechungsindex des aufgeklebten Substrates, das zusätzliche Schichten aus hoch und niedrigbrechenden Materialien beinhalten kann. Die Beschreibung der Interferenzstrukturen kann - wie unten noch ausführlich beschrieben - mit Hilfe eines einfachen Drei-Phasen-Modells erfolgen, bei dem die Klebeschicht zwischen jeweils halbunendlichen Medien (Phasen) aus Luft (oberhalb) und Si-Diode (unterhalb) betrachtet wird. Dieses Modell ist in Fig. 2 dargestellt und weist für die verschiedenen Medien unterschiedliche komplexe Brechungsindizes $n_i$ aus: für Luft (no), Klebstoff ($n_2$) und Si-Diode ($n_1$). Die Dicke der aufgebrachten Klebeschicht ist mit $d_2$ bezeichnet und $\varphi_e$ repräsentiert den Einfallswinkel des Lichts.

Im Stand der Technik ist zur Unterdrückung von Schichtinterferenzen aus der US 7 626 241 B1 bekannt, die Dünnschichtinterferenz-Rippel bei beschichteten Sensoroberflächen durch verschieden eingestellte Dicken in unterschiedlichen Bereichen des Dünnfilms zu reduzieren. Wegen der Integration der Sensoren in integrierten Schaltkreisen mit eingebetteter Signalverarbeitung und zwischengeschalteten Metallschichten ist die Siliziumdioxidschicht zur Passivierung des Siliziums relativ dick und ist deshalb für die Interferenzrippel verantwortlich. Wegen des Sprungs der Brechungsindizes zwischen dem Si-Sensor und der Passivierungsschicht wird letztere mit zwei unterschiedlichen Dicken über der lichtempfindlichen Sensorfläche aufgetragen, wodurch sich die Interferenzen idealerweise wegmitteln. Nachteilig dabei ist, dass diese partiellen Dickendifferenzen direkt beim ohnehin schon komplexen Waferherstellungsprozess für jede lichtempfindliche Fläche hergestellt werden müssen.

Eine weitere dem Grundansatz der Interferenzrippel-Unterdrückung dienende Lösung ist in der JP 05-316284 A für einen Bildaufnehmer mit Unterdrückung des Interferenzmusterrauschens beschrieben. Dabei wird ein Deckglas geneigt gegenüber dem Bildsensor angeordnet, wobei dieselbe Anzahl von Interferenzmustern auf jedes Sensorelement fällt, sodass das Interferenzmusterrauschen ausgeglichen wird, indem die durchschnittliche Lichtintensität, die jedes Sensorelement empfängt, angeglichen und von den einzelnen Sensorelementen nicht mehr wahrgenommen wird.

In der US 2010/026866 A1 ist ein weiterer Festkörperbildsensor offenbart, der einen photoelektrischen Wandlerbereich aufweist, der das einfallende Licht in ein elektrisches Signal wandelt, wobei eine Gate-Isolierschicht eines MOS-Transistors im peripheren Schaltkreisbereich und im Pixelbereich aus Siliziumoxinitrid zusammengesetzt sind, und eine Oxidschicht über dem photoelektrischen Konversionsbereich im Pixelbereich angeordnet ist, um Weißdefekt und Dunkelstrom zu unterdrücken.

Des Weiteren ist aus der EP 2 009 696 A2 ein rückseitenbelichteter Bildsensor bekannt, der eine Photodiode unterhalb der oberen Oberfläche des Halbleitersubstrats aufweist zum Empfangen des Rückseitenlichts und ein reflektierendes Gate auf der Photodiode über der oberen Frontoberfläche, um ein Bias-Signal zur Steuerung der Verarmungszone der Photodiode zu erhalten.

US 7,330,266 offenbart ein lichtempfindliches Element mit einer darauf angeordneten transparenten Platte, wobei die transparente Platte keilförmig ist oder eine Treppenform aufweist.

US 7,626,241 offenbart einen optischen Photodiodensensor mit einem dünnen Film aus einem Material mit darauf angeordneten Bereichen unterschiedlicher Dicke.

US 2008/278665 offenbart einen Fotosensor, der auf einem ersten Substrat angeordnet ist, wobei rote, grüne und blaue Farbfilter auf einem zweiten Substrat angeordnet sind, wobei das zweite Substrat dem ersten Substrat zugewandt ist.

Der Erfindung liegt die Aufgabe zugrunde, eine neue Möglichkeit zur Unterdrückung der Interferenzrippel von optischen Sensoren, die bei der Hinzufügung von Substraten mit optisch funktionellen Beschichtungen entstehen, zu finden, die eine einfache Realisierung ohne kompliziert auszuführende Anpassungsschichten bei der Herstellung der Sensoren gestattet.

Erfindungsgemäß wird die in Anspruch 1 beanspruchte Sensoranordnung bereitgestellt.

Eine Sensorpassivierung ist aus einer Kombination von dünner $SiO_2$-Schicht und entspiegelungsangepasster $Si_3N_4$-Schicht zusammengesetzt ist, wobei die $SiO_2$-Schicht eine Dicke im Bereich von 5 bis 10 nm aufweist. Über der Sensorpassivierung ist ein mindestens ein drei spektral unterschiedlichen Interferenzfilter tragendes Substrat angeordnet, das mit dem Sensor mittels eines Klebstoffs verbunden ist und zwischen einer lichtempfindlichen Sensorfläche und einem zugeordneten optischen Filter einen Zwischenraum im Sinne einer optischen Schicht mit einem gegenüber dem Sensor niedrigeren Brechungsindex ausbildet, und dass die optische Schicht eine Höhenvariation über der zugeordneten lichtempfindlichen Sensorfläche aufweist.

Die Höhenvariation ist durch eine Verkippung des Substrats gegenüber der lichtempfindlichen Sensorfläche realisiert. Dazu sind zweckmäßig Abstandshalter zur Verkippung des Substrats auf dem Substrat in verschiedener Höhe vorhanden, wobei die definierten Höhen der Abstandshalter durch aufeinanderfolgende Schichten von ausgewählten Filtern bekannter Schichtdicken, die in gleicher Dicke wie die der Sensorfläche zugeordneten optischen Filter erzeugt sind, eingestellt sind.

In einer nicht beanspruchten Variante ist die Höhenvariation zweckmäßig durch eine definierte Abstufung des Substrats gegenüber der lichtempfindlichen Sensorfläche in gleichgroßen Bereichen zur Aufbringung mindestens zweier höhenversetzter Filtersegmente realisiert. Vorzugsweise wird dabei die Abstufung des Substrats durch strukturierte Glasabscheidung auf dem Substrat erzeugt.

Der Zwischenraum zwischen lichtempfindlicher Sensorfläche und zugeordnetem optischem Filter kann mit einem beliebigen optischen Medium gefüllt sein. Vorteilhaft ist er mit einer Klebeschicht gefüllt. Er kann auch zweckmäßig als optisches Medium eine Luftschicht enthalten, die von Klebstoff wenigstens teilweise umschlossen ist. Alternativ sind auch Flüssigkeiten, z.B. Immersionsöle, einsetzbar.

Die Verkippung des Substrats ist vorzugsweise so eingestellt, um Interferenzrippel verschiedener Frequenzen mit einer Anzahl von Überlagerungsperioden zu erzeugen, die sich durchmischend überlagern und kompensieren. Dabei ist die Höhenvariation $\Delta h$ für eine optimale Verkippung zweckmäßig gemäß der Gleichung $\Delta h = x \cdot \lambda / (2n_2)$ ermittelbar.

Die definierte Abstufung des Substrats zur Erzeugung einer Höhenvariation $\Delta h$ ist vorteilhaft so eingestellt, um Interferenzrippel verschiedener phasenverschobener Frequenzen zu erzeugen, die sich auslöschend überlagern und kompensieren. Dabei ist die Höhenvariation $\Delta h$ zur Abstufung des Substrats bei Anwendung von zwei Filtersegmenten für eine optimale Auslöschung gemäß der Gleichung $\Delta h = \frac{1}{2}\lambda/(2n_2)$ ermittelbar.

Die Abstandshalter für die Verkippung des Substrats sind vorzugsweise als Filterstacks durch sukzessive aufgebrachte Filterschichten ausgebildet, wobei die Filterschichten der Filterstacks in gleicher Art und Höhe wie einzelne optische Filter aufgebaut sind.

Die Erfindung basiert auf der Grundüberlegung, dass definierte Dickenabstufungen von Passivierungsschichten oder zusätzliche Entspiegelungsschichten bei der Herstellung der Sensoren zu kompliziert oder fehleranfällig sind. Außerdem sind die bei Bestückung mit Interferenzfiltern erforderlichen separaten Substrate nur durch Klebeprozesse mit dem Sensor verbindbar, wodurch eine weitere, Interferenzen erzeugende Schicht berücksichtigt werden muss. Die Erfindung nutzt deshalb eine spezielle Ausführung der Sensorpassivierung aus Siliziumdioxidschicht ($SiO_2$) und Siliziumnitridschicht ($Si_3N_4$), wobei die $SiO_2$-Schicht über dem kompletten Bereich der lichtempfindlichen Sensorflächen auf eine Dicke zwischen 5 und 10 nm reduziert ist und die $Si_3N_4$-Schicht auf eine angepasste Dicke zwischen 30 und 70 nm für eine optimale Entspiegelung auf den sichtbaren (VIS-) Spektralbereich eingestellt wird. Die Dicke $d_1$ der $Si_3N_4$-Schicht berechnet sich aus dem Brechungsindex $n_1$ von $Si_3N_4$ (ca. 1,95) und der Wellenlänge $\lambda$ für eine optimale Entspiegelung gemäß $d_1 = \lambda/(4 n_1)$.

Die Schichtinterferenzen einer darüber liegenden Klebeschicht zur Fixierung des Substrats mit wenigstens einem mehrschichtigen optischen Filter (z.B. Interferenzfarbfilter) erfolgt erfindungsgemäß in der Weise, dass das Substrat mit den Filterschichten zum Sensor gerichtet und mit gegenüber dem Sensor reproduzierbar definiertem unterschiedlichem Abstand zur Unterdrückung der Interferenzrippel angeordnet ist. Der Zwischenraum bis zur Sensorpassivierung ist vorzugsweise mit dem verwendeten Klebstoff gefüllt, kann aber auch Luft oder eine Flüssigkeit sein. Der unterschiedliche Abstand, der durch die Höhe des Zwischenraums über der Sensorpassivierung variiert wird, führt zur Unterdrückung der Interferenzrippel, indem durch Überlagerung (oder Mischung) unterschiedlicher Schichtinterferenzen im Zwischenraum eine Optimierung der optischen Kopplung realisiert wird.

Die Überlagerung im Zwischenraum kann in einer ersten Variante durch Verkippung (Schrägstellung) oder in einer zweiten, nicht beanspruchten Variante durch Abstufungen im Substrat der optischen Filter erfolgen. Bei der Verkippung entsteht ein Gemisch aus Interferenzrippeln verschiedener Frequenzen mit x Überlagerungsperioden. Je mehr unterschiedliche Perioden sich überlagern, umso gleichmäßiger wird die Durchmischung.

Alternativ besteht die nicht beanspruchte Möglichkeit, das Substrat stufenförmig zu herzustellen, beispielsweise durch strukturierte Glasabscheidung, sodass im Zwischenraum über der lichtempfindlichen Sensorfläche mindestens zwei gleichgroße Bereiche unterschiedlicher Höhe entstehen, deren Schichtinterferenzmuster sich gegenseitig auslöschen (Bedingung: $\Delta h = \frac{1}{2} \lambda / 2 n_2$). Werden drei oder vier gleichgroße Bereiche hergestellt, so muss die Auslöschungsbedingung für ⅓ λ bzw. ¼ λ angepasst werden.

Durch die Erfindung ist es möglich, die Interferenzrippel von optischen Sensoren, die aus der Hinzufügung von Substraten mit optisch funktionellen Beschichtungen entstehen, zu unterdrücken und einfach zu realisieren, ohne dass kompliziert auszuführende Anpassungsschichten erforderlich sind.

Die Erfindung wird nachfolgend anhand von Ausführungsbeispielen näher erläutert. Dabei zeigen die Zeichnungen:

Fig. 1: eine Prinzipdarstellung einer nicht beanspruchten Vorrichtung mit entspiegelnder Sensorpassivierung und Höhenvariation des Abstandes eines optischen Filters gegenüber einer lichtempfindlichen Sensorfläche, das sich auf der Unterseite eines Substrats befindet, wobei das Substrat zugleich den oberen Abschluss der Sensoranordnung bildet;

Fig. 2: ein Drei-Phasen-Modell zur Erläuterung der Schichtinterferenz an einer Schicht mit hohem Unterschied der Brechungsindizes zu den angrenzenden Medien (Phasen);

Fig. 3: eine Darstellung des Reflexionsgrades über der Wellenlänge für drei unterschiedliche Schichtdicken im Phasenmodell von Fig. 2;

Fig.4: eine Sensoranordnung, die aus bekannten herkömmlichen Komponenten, einem Sensor mit Passivierung und einem Substrat mit optischen Filtern, ohne Interferenzunterdrückende Maßnahmen zusammengesetzt ist;

Fig. 5a: eine Darstellung der Interferenzen, wie sie durch die Sensorpassivierung auf einem Si-Wafer und nachfolgender Verklebung eines Substrats mit einem transparenten Klebstoff gemäß dem Aufbau von Fig. 4 entstehen;

Fig. 5b: eine Darstellung der resultierenden spektralen Empfindlichkeit für einen Sensor mit Y-Normspektralwertfunktion ohne Anpassung des darüber befindlichen Schichtsystems;

Fig. 6a: eine Darstellung der Transmission über der Wellenlänge für ein entspiegelungsoptimiertes Schichtsystem der Sensorpassivierung aus $SiO_2$- und $Si_3N_4$-Schicht in einer bevorzugten Ausführung mit 5 nm $SiO_2$ und 45 nm $Si_3Ni_4$;

Fig. 6b: eine Darstellung der Interferenzen für eine Ausführung des Zwischenraums zwischen Sensor und filterbeschichtetem Substrat als Klebeschicht mit einem Brechungsindex von 1,55 für zwei unterschiedliche Schichtdicken der Klebeschicht ohne Variation der Schichtdicke über der lichtempfindlichen Sensorfläche;

Fig. 7: eine alternative, nicht beanspruchte Ausführungsform mit entspiegelnder Sensorpassivierung und Höhenvariation des Abstandes eines optischen Filters gegenüber dem Sensor durch Abstufung des Substrats in zwei gleichgroßen Bereichen über der lichtempfindlichen Sensorfläche;

Fig. 8: eine prinzipielle Darstellung eines Farbsensors mit drei separaten Sensorflächen und einer Klebeschicht im Zwischenraums zwischen den Sensorflächen und einem Substrat, das mit drei spektral unterschiedlichen Interferenzfiltern beschichtet ist, wobei das Substrat dadurch mit reproduzierbar definierter Höhenvariation eingestellt ist, dass aus allen separat beschichteten Interferenzfiltern höhendefinierte Filterstapel (Filterstacks) als exakt positionierte Abstandshalter einseitig auf dem Substrat aufgebracht sind;

Fig. 9a: eine Darstellung des resultierenden Reflexionsgrades für zwei gegenüber der Sensorfläche unterschiedlich verkippten Filterstruktur in Gegenüberstellung zu einer parallel ausgerichteten Filterstruktur (Zwischenraum mit konstant 1000 nm dicker Klebeschicht);

Fig. 9b: eine höher aufgelöste Darstellung des resultierenden Reflexionsgrades aus Fig. 9a für eine verkippte Filterstruktur;

Fig. 10: eine perspektivische Darstellung eines speziell ausgeführten Substrats mit verschiedenen Farbfiltern, bei deren separater Beschichtung drei sukzessive Beschichtungsprozesse zur Herstellung von Farbfilterstacks als definiert geformte Abstandshalter gegenüber dem Sensor genutzt wurden.

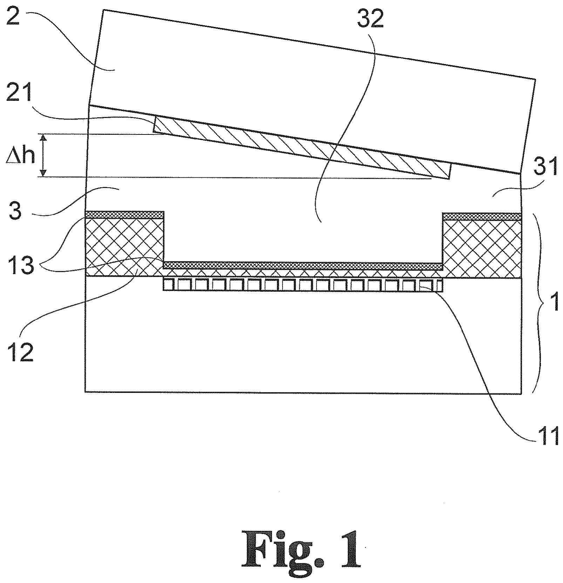

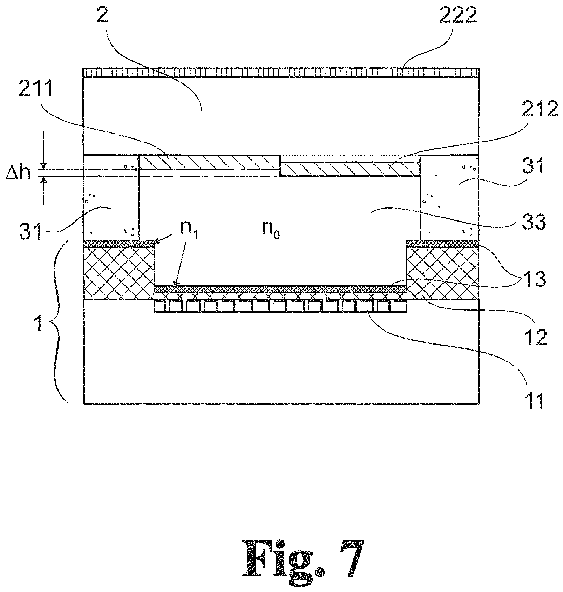

Der grundsätzliche Aufbau einer erfindungsgemäßen Sensoranordnung gemäß Fig. 1 umfasst einen siliziumbasierten Sensor 1 mit einer lichtempfindlichen Sensorfläche 11 und einer Sensorpassivierung aus einer $SiO_2$-Schicht 12 und $Si_3N_4$-Schicht 13, ein Substrat 2 mit wenigstens einem optischen Filter 21, das über der lichtempfindlichen Sensorsfläche 11 eine Höhenvariation $\Delta$h aufweist, und einen Zwischenraum 3, der - ohne Beschränkung der Allgemeinheit - in der Ausführung von Fig. 1 mit einem Klebstoff 31 gefüllt ist und eine homogene, nichtabsorbierende Klebeschicht 32 bildet. Es ist aber - wie ausschließlich in der Ausführung von Fig. 7 gezeigt - auch möglich, dass der Zwischenraum 3 als Luftschicht 33 ausgebildet oder mit einer Flüssigkeit (nicht gezeichnet), beispielsweise Immersionsöle, wie sie aus der Mikroskopie bekannt sind, gefüllt ist, wobei der Klebstoff 31 dann nur die Randbefestigung zwischen Sensor 1 und Substrat 2 bildet. Das Substrat 2 bildet zugleich den oberen Abschluss der Sensoranordnung, wobei das Substrats 2 das mindestens eine optische Filtersystem 21 an der unteren, dem Sensor 1 zugewandten Seite aufweist und auf der oberen Außenfläche eine oder mehrere zusätzliche äußere Beschichtungen 22 (z.B. zur Entspiegelung oder IR-Abschirmung) aufgebracht sein können.

Wie bereits oben erwähnt, führt die Verbindung eines optischen Sensors 1 mit einem funktionalen Substrat 2 mit optischen Filtern (z.B. Deckglas mit Interferenzfiltern) zu unerwünschten Interferenzrippel des detektierten Signals zum einen durch die Sensorpassivierungsschichten, $SiO_2$-Schicht 12 und $Si_3N_4$-Schicht 13, und zum anderen durch das Medium im Zwischenraum 3 (Klebstoff 31 oder Luft 33) zum Substrat 2 (Deckglas). Jede Art von Interferenzrippeln für sich beeinflusst die aus Basisempfindlichkeit des Sensors 1 und der Transmissionseigenschaft des aufgesetzten Substrates 2 resultierende spektrale Empfindlichkeit (siehe Fig. 5b). Die Amplitude und die Frequenz der Interferenzrippel orientiert sich an den Brechungsindizes und den Schichtdicken.

Eine allgemeine Beschreibung dieser Interferenzstrukturen kann in einem einfachen Drei-Phasen-Modell erfolgen. Hierbei besteht die oberste halbunendliche Phase aus Luft ($n_o$), die mittlere repräsentiert den Klebstoff ($n_2$) und die untere halbunendliche Phase die Si-Diode ($n_1$). Dieser Aufbau ist in Fig. 2 gezeigt, wobei $d_2$ die Dicke der auf der Si-Diode aufgebrachten Schicht, $n_i$ = 0, 1, 2 den komplexen Brechungsindex des entsprechenden Mediums der einzelnen Phasen und $\varphi_e$ den Einfallswinkel des Lichts bezeichnen.

Generell gilt für die komplexen Reflexionskoeffizienten für senkrecht und parallel polarisiertes Licht an eine Grenzfläche zwischen zwei Medien (1 und 2) unter senkrechtem Lichteinfall:

$$r_p = \frac{n_2 - n_1}{n_2 + n_1}$$

$$r_s = \frac{n_1 - n_2}{n_1 + n_2} \qquad (1)$$

Betrachtet man nun wieder das beschrieben 3-Phasen-Modell, so ergeben sich durch den Schichtaufbau die Reflexionskoeffizienten zu:

$$r_p = \frac{r_p^{01} + r_p^{12} e^{2i\beta}}{1 + r_p^{01} r_s^{12} e^{2i\beta}}$$

$$r_s = \frac{r_s^{01} + r_s^{12} e^{2i\beta}}{1 + r_s^{01} r_p^{12} e^{2i\beta}} \qquad (2)$$

$r_{ij}$ bezeichnet hierbei den Reflexionskoeffizienten zwischen den Schichten i und j und $\beta$ die einheitslose Phasendicke. Für diese gilt unter senkrechtem Lichteinfall:

$$\beta = \frac{2\pi \cdot d \cdot n_1}{\lambda} \qquad (3)$$

Der Reflexionsgrad ergibt sich nun aus dem Quadrat (Multiplikation mit dem konjugiert komplexen) Reflexionskoeffizienten, wobei für unpolarisiertes Licht die Anteile für senkrechtes und paralleles gleich sind. Somit ergibt sich für die Reflexion innerhalb diese Modells:

$$R = \frac{\left(r_p^{01}\right)^2 + \left(r_p^{12}\right)^2 + 2 \cdot \left(r_p^{01}\right) \cdot \left(r_p^{12}\right) \cdot \cos\left(\frac{4\pi \cdot d \cdot n_1}{\lambda}\right)}{1 + 2 \cdot \left(r_p^{01}\right)^2 \left(r_p^{12}\right)^2 \cos\left(\frac{4\pi \cdot d \cdot n_1}{\lambda}\right)} \quad (4)$$

Legt man bei Fig. 4 einen vereinfachten Aufbau mit den nichtabsorbierenden Medien: Filter: $n_0 = 2{,}38$, Klebstoff: $n_2 = 1{,}554$ und Silizium: $n_1 = 4$ zu Grunde, so ergeben sich die in Fig. 3 gezeigten Reflexionsgrade für die in der Legende angegebenen verschiedenen Schichtdicken $d_2$ des Klebstoffs 31.

Aufgrund der nicht reproduzierbaren Dicken $d_2$ des Klebstoffs 31 können diese Effekte nicht mit in das Design des/der Filter 21 sowie der gesamten Sensoranordnung einfließen. Der Nachteil der in Fig. 3 erkennbaren Interferenzen ist, dass die gewünschte spektrale Charakteristik des Sensors 1 verfälscht wird. Darüber hinaus ist die Frequenz der Verfälschung nicht vorhersehbar und somit nicht korrigierbar.

Durch eine erfindungsgemäße Höhenvariation $\Delta h$ des Abstandes des Filters 21 über der lichtempfindlichen Sensorfläche 11 kommt es - aufgrund der lokal unterschiedlichen Schichtdicke $d_2$ - zur ungestörten Überlagerung (Superposition) sehr vieler, wie der in Fig. 3 gezeigten Interferenzstrukturen. Infolge einer solchen Überlagerung wird das resultierende Gesamtinterferenzmuster minimiert.

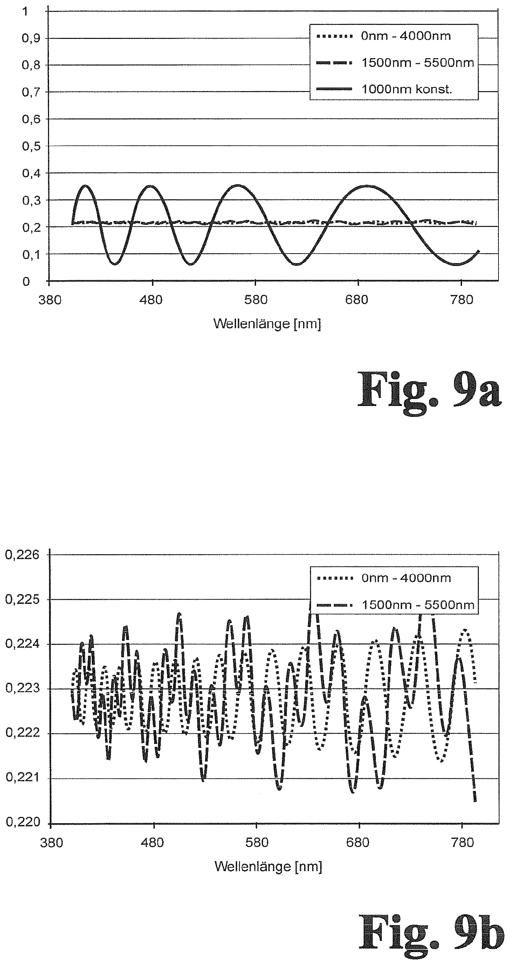

Fig. 9a und 9b zeigen die resultierenden Reflexionsgrade eines gemäß Fig. 1 verkippten Filters 21. Bei hinreichend großer Verkippung ergibt sich ein nahezu interferenzfreies optisches Signal. Um das resultierende Mischinterferenzspektrum zu berechnen, werden die Reflexionsgrade mit Hilfe von Gleichung 4 in einem bestimmten Schichtdickenbereich für jede Wellenlänge integriert. Es wurden beispielhaft neben der Verkippung von null auf 4000 nm auch Verkippungen von 1500 nm auf 5500 nm betrachtet. Zu den verbleibenden reduzierten Interferenzrippeln (Restwelligkeit des Reflexionsgrades) ist im Diagramm von Fig. 9a zusätzlich zum Vergleich die normale interferenzbehaftete Reflexion an einer 1000 nm dicken, parallelen Klebeschicht 32 (entsprechend Fig. 4) dargestellt. In der darunter befindlichen Fig. 9b ist durch eine hochauflösende Darstellung die verbleibende, aber in Fig. 9a kaum erkennbare Restwelligkeit des Reflexionsgrades deutlicher veranschaulicht.

Das anzupassende optische Schichtsystem der Sensoranordnung besteht aus den folgenden Schichten:

0. Schicht:

Diese Schicht steht als Sensor-Basismaterial, wie z.B. PIN-Dioden, CMOS-Dioden und TFA-Strukturen, zur Verfügung und wandelt das einfallende Licht in einen Photostrom. Sie stellt die vorgegebene Grundlage des Schichtsystems dar und ist durch einen hohen Brechungsindex aus ($n_0 > 4$) gezeichnet.

1. Schicht:

Die erste Schicht über dem Sensor 1 wird mindestens aus einer $SiO_2$-Schicht 12 gebildet. Zur Minimierung der Interferenz in einer Passivierungsschicht gibt es mehrere technischen Lösungen, wie beispielsweise eine sektorielle Abstufung der Passivierungsschichtdicke um $\lambda/(4n_1)$ gemäß US 7 626 241 B1 oder die Anpassung der Dicken auf optimale Entspiegelung, wie sie hier angewendet wird. Bei der vorliegenden Erfindung basiert die Sensorpassivierung auf einer Kombination aus $SiO_2$-Schicht 12 und $Si_3N_4$-Schicht 13. Diese Passivierungsschichtfolge enthält eine sehr dünne $SiO_2$-Schicht 12 und eine spektral angepasste Dicke der $Si_3N_4$-Schicht 13. Während die $SiO_2$-Schicht 12 im Bereich der lichtempfindlichen Sensorfläche 11 eine Dicke $d_0$ von lediglich 5-10 nm aufweist, durch die diese in der Interferenzwirkung unwirksam wird, kann die $SiO_2$-Schicht in den übrigen Bereichen des Sensors 1 übliche Schichtdicken zwischen 2 und 7 $\mu$m aufweisen. Die spektral angepasste Dicke $d_1$ der $Si_3N_4$-Schicht 13 berechnet sich aus dem Brechungsindex $n_1 = 1{,}95$ von $Si_3N_4$ und der für die Optimierung angesetzten Wellenlänge $\lambda$ zu

$$\Delta d_1 = \lambda/(4n_1) \quad (5)$$

Für eine optimale Entspiegelung im VIS-Spektralbereich ergibt sich damit für die $Si_3N_4$-Schicht 13 eine Dicke

$d_1$ zwischen 30 und 70 nm.

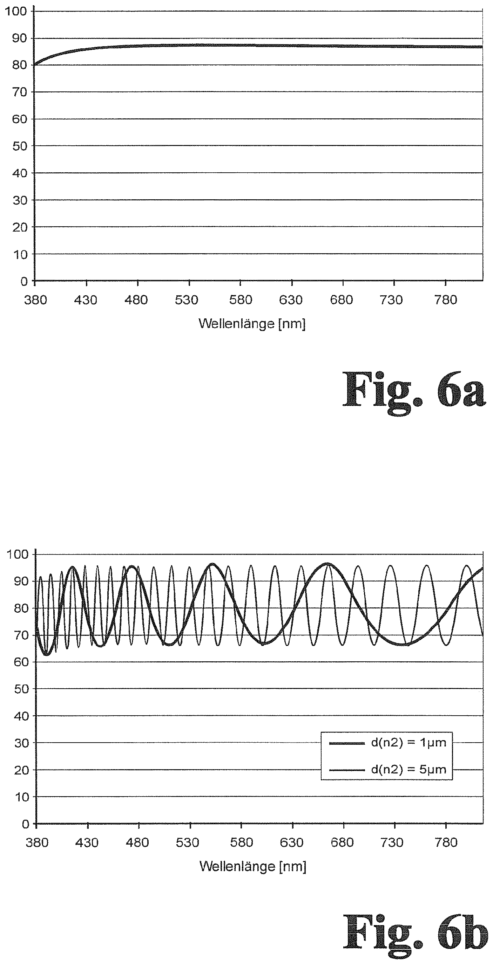

Für ein besonders vorteilhaftes Beispiel, bei dem die $SiO_2$-Schicht 12 eine Dicke $d_0$ = 5 nm und die $Si_3N_4$-Schicht 13 eine Dicke $d_1$ = 45 nm aufweisen, ist in Fig. 6a das Transmissionsverhalten über der Wellenlänge dargestellt und zeichnet sich durch hohe Absolutwerte sowie hohe Konstanz der Transmission (außerhalb des blauen Spektralbereichs) aus und lässt keine Interferenzstörwelligkeit erkennen.

2. Schicht:

Die zweite Folgeschicht vor dem optischen Substrat 2 besitzt den Brechungsindex $n_2$. Beispiele für diese zweite Schicht sind optisch transparente Klebstoffe 31 oder dünne Luftspalte. Sehr dünne Schichten lassen sich technologisch oft nicht reproduzierbar umsetzen, sodass je nach Schichtdicke die Frequenz der Interferenzrippel variiert. Je dicker die Schichten sind, umso hochfrequenter werden die Störungen. Das ist in Fig. 6b für zwei ausgewählte Dicken $d_2$ = 1000 nm und $d_2$ = 5000 nm eines Klebstoffs 31 mit dem Brechungsindex $n_2$ = 1,55 verdeutlicht. Ein vergleichbares Verhalten ergibt sich für alle nichtabsorbierenden Klebstoffe und transparenten Medien mit einem Brechungsindex im Bereich von 1 bis 3,5.

Zur Unterdrückung dieser Interferenzrippel wird die Dicke $d_2$ der zweiten Schicht über der lichtempfindlichen Sensorfläche 11 variiert, sodass durch Überlagerung von Schichtinterferenzen eine Optimierung der optischen Kopplung realisiert wird. Diese Überlagerung kann durch Verkippung oder durch Abstufungen des nachgeordneten Substrats 2 erfolgen.

Bei der Verkippung, wie bereits mit Bezug auf Fig. 1 beschrieben, entsteht ein Gemisch aus Interferenzrippeln verschiedener Frequenzen mit x Überlagerungsperioden. Je mehr Perioden sich überlagern, umso gleichmäßiger wird die Durchmischung.

$$\Delta h = x \cdot d_2 = \lambda \,/(2n_2) \qquad\qquad (5)$$

Bei einer Höhenvariation $\Delta h$ von 2000 nm über dem optisch aktiven Bereich (lichtempfindliche Sensorfläche 11) ergibt sich für eine Wellenlänge $\lambda$ = 550 nm und einem Brechungsindex $n_2$=1,55 eine Überlagerung von 11 Perioden. Bei einer Amplitude des Störsignals von 25% bleibt eine Restwelligkeit von weniger als 2 %.

Alternativ besteht die Möglichkeit, die Höhenvariation $\Delta h$ des Abstandes des Filters 21 zur lichtempfindlichen Sensorfläche 11 durch eine stufenförmige Ausführung des Substrats 2 zu erzeugen, indem zur Positionierung von zwei höhenversetzten Filtersegmenten 211 und 212 zwei gleichgroße Sektoren (z.B. Halbkreise) im Substrat 2 abgestuft um 2000 nm hergestellt werden, wie es als Seitenansicht schematisch in Fig. 7 dargestellt ist.

Die abgestuften Sektoren des Substrats 2 können beispielsweise durch strukturierte Glasabscheidung auf dem Substrat 2 erzeugt werden, bevor die Filtersegmente 211 und 212 höhenversetzt aufgetragen werden. Durch die Verwendung von gleichmäßigen Spacern (nicht gezeichnet) ist die Filterausrichtung parallel zur Sensorfläche 11 ausgebildet und das Substrat 2 im Randbereich um die lichtempfindliche Sensorfläche 11 herum mit Klebstoff 31 befestigt und es entstehen aufgrund der durch das abgestufte Substrat 2 höhenversetzten Filtersegmente 211 und 212 im Zwischenraum 3 oberhalb der Sensorfläche 11 zwei gleichgroße Bereiche unterschiedlichen Abstandes. Eine in diesem Beispiel im Zwischenraum 3 als zweite Schicht wirkende Luftschicht 33 ist zumindest teilweise von dem Klebstoff 31 umgeben. Der hier gestuft ausgelegte Zwischenraum 3 kann aber auch mit einer Flüssigkeit oder mit einer durchgehenden Klebeschicht 32 ausgefüllt sein.

Die optimale (auslöschende) Überlagerung der Schichtinterferenzen ergibt sich bei einer Höhenvariation $\Delta h$ der Luftschicht 33 (wie auch für jedes andere im Zwischenraum 3 verwendbare Medium) zu:

$$\Delta h = \tfrac{1}{2}\lambda \,/(2n_2). \qquad\qquad (6)$$

3. Schicht:

Die dritte Schicht der Sensoranordnung wird durch das Substrat 2 gebildet, das vorzugsweise ein Glassubstrat mit mindestens einem optischen Filter 21, z.B. zur spektralen Filterung, ist und zusätzlich wenigstens eine äußere Beschichtung 22, beispielsweise in Form eines AR-Filters 221 (Antireflexionsfilter) oder eines IR-Kantenfilters 222 (nur in Fig. 7 gezeigt) aufweisen kann.

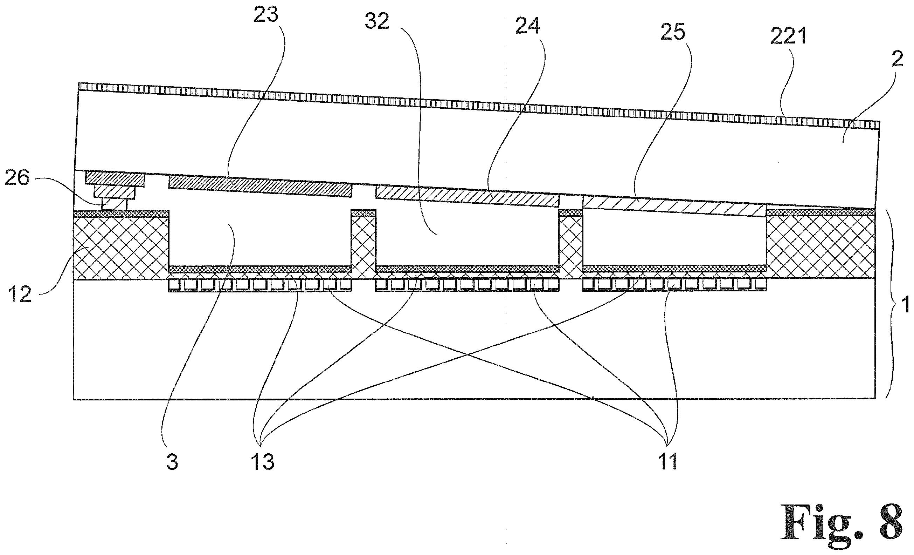

In einer vorteilhaften Ausführung gemäß Fig. 8 ist eine Farbsensoranordnung mit drei spektral unterschiedlichen Interferenzfiltern 23, 24, 25 gezeigt. Alle drei Interferenzfilter 23, 24, 25 sind auf dem Substrat 2 derart aufgebracht, dass sie jeweils einer separaten lichtempfindlichen Sensorfläche 11 zugeordnet sind. Die Sensorpassivierung ist im Bereich der lichtempfindlichen Sensorflächen 11 durch die spezielle Kombination aus sehr dünner $SiO_2$-Schicht 12 und

entspiegelungsangepasster $Si_3N_4$-Schicht 13, wie oben zur ersten Schicht beschrieben, ausgeführt. Zwischen- und Randbereiche sind mit deutlich größere Mächtigkeit hergestellt. Auf diesen Randbereichen ist das Substrat 2 definiert verkippt abgestützt, wobei das Substrat 2 einseitig direkt aufliegt und an der gegenüberliegenden Kante durch Abstandshalter 26 in einer definierten Verkippung schräg zum Sensor 1 gehalten wird. Der Zwischenraum 3 ist in diesem Fall mit Klebstoff 31 vollständig ausgefüllt und erzeugt über jeder lichtempfindlichen Sensorflächen 11 eine Klebeschicht 32 mit einer kontinuierlichen Höhenvariation $\Delta h$, sodass jede Sensorfläche 11 durch die Zuordnung der spektral unterschiedlichen Interferenzfilter 23, 24 und 25 spektral-selektive Signale ohne Interferenzrippel aufgenommen werden können.

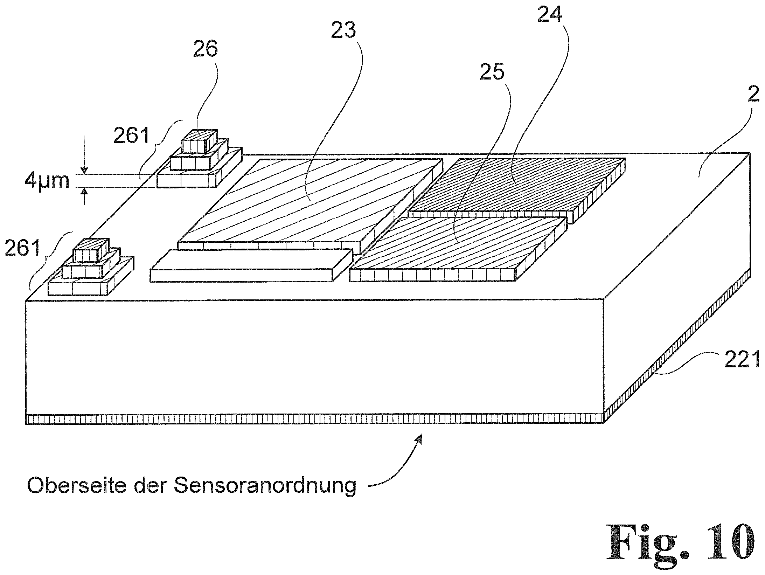

Fig. 10 zeigt die Beschaffenheit des Substrats 2 nochmals in einer perspektivischen Darstellung in invertierter Lage und verdeutlicht die definierte Herstellung der Abstandshalter 26 als zusammen mit der Beschichtung der spektral unterschiedlichen Interferenzfilter 23, 24 und 25 erzeugte Filterstacks 261. Die Filterstacks 261 bestehen dabei aus gleichen Filterschichten in gleicher Art und Höhe wie die Interferenzfilter 23, 24 und 25. Im Unterschied zu der schematischen Seitenansicht der Sensoranordnung von Fig. 8 zeigt die Substratansicht von Fig. 10 eine bevorzugte räumliche Verteilung der spektralen Interferenzfilter 23, 24 und 25, zu der die lichtempfindlichen Sensorflächen 11 entsprechend ausgerichtet zuzuordnen sind.

Der Vorteil der erfindungsgemäßen Höhenvariation $\Delta h$ des Abstands des Filters 21 zur lichtempfindlichen Sensorfläche 11 besteht gegenüber dem Stand der Technik darin, dass durch diese Maßnahme die Einflüsse der störenden Interferenzstrukturen auf die optische Antwort des Systems minimiert werden. Mit Hilfe eines solchen definierten Aufbaus können die optischen Filter 23, 24, 25 für die gewünschte spektrale Charakteristik einer Farbsensoranordnung gemäß den Figuren 8 und 10 sehr genau vorausberechnen werden.

Bezugszeichenliste

| | |
|---|---|
| 1 | Sensor |
| 11 | lichtempfindliche Sensorfläche |
| 12 | $SiO_2$-Schicht |
| 13 | $Si_3N_4$-Schicht |
| 2 | Substrat |
| 21 | (optisches) Filter(-system) |
| 211, 212 | (höhenversetztes) Filtersegment |
| 22 | äußere Beschichtung |
| 221 | AR-Filter |
| 222 | IR-Kantenfilter |
| 23, 24, 25 | spektral unterschiedliche Interferenzfilter |
| 26 | Abstandshalter |
| 261 | Filterstack |
| 3 | Zwischenraum (zwischen Sensorpassivierung und |
| 31 | Klebstoff |
| 32 | Klebeschicht |
| 33 | Luftschicht |
| $d_0$ | Dicke der $SiO_2$-Schicht |
| $d_1$ | Dicke der $Si_3N_4$-Schicht |
| $d_2$ | Dicke der Klebeschicht (des Zwischenraums) |
| $\Delta h$ | Höhenvariation des Zwischenraums (der Klebeschicht) |
| $n_0$ | Brechungsindex (der Luft) |
| $n_1$ | Brechungsindex (der $Si_3N_4$-Schicht) |
| $n_2$ | Brechungsindex (des Klebstoffs) |
| x | Anzahl der Überlagerungsperioden |
| $\varphi_e$ | Einfallswinkel |

**Patentansprüche**

1. Sensoranordnung zur Farbmessung mit Interferenzrippelunterdrückung enthaltend mindestens einen siliziumbasierten optischen Sensor mit mindestens drei separaten lichtempfindlichen Sensorflächen und einer Sensorpassivierung, die aus einer Kombination von $SiO_2$-Schicht (12) und entspiegelungsangepasster $Si_3N_4$-Schicht (13) zusammengesetzt ist, **dadurch gekennzeichnet, dass**

- die SiO$_2$-Schicht (12) eine Dicke im Bereich von 5 bis 10 nm aufweist,
- über der Sensorpassivierung ein mindestens drei spektral unterschiedliche Interferenzfilter (21; 23, 24, 25) tragendes Substrat (2) angeordnet ist, das mit dem Sensor (1) mittels eines Klebstoffs (31) verbunden ist und zwischen jeder der lichtempfindlichen Sensorflächen (11) und einem der jeweiligen Sensorfläche (11) zugeordneten Interferenzfilter (21) einen Zwischenraum (3) im Sinne einer optischen Schicht (32; 33) mit einem gegenüber der Sensorpassivierung des Sensors (1) niedrigeren Brechungsindex (n$_2$) ausbildet, und
- die optische Schicht (32; 33) über jeder zugeordneten lichtempfindlichen Sensorfläche (11) eine Höhenvariation ($\Delta$h) aufweist, wobei die Höhenvariation ($\Delta$h) durch eine Verkippung des Substrats (2) mit den optischen Filtern (21; 23, 24, 25) gegenüber den lichtempfindlichen Sensorflächen (11) realisiert ist, wobei Abstandshalter (26) zur definierten Einstellung der Substratverkippung auf dem Substrat (2) an vorgegebenen Positionen vorhanden sind, die im Prozess der Herstellung der optischen Filter (21; 23, 24, 25) durch aufeinanderfolgendes Beschichten von Filtern (21; 23, 24, 25) bekannter Schichtdicken in definierter Höhe erzeugt sind.

2. Sensoranordnung nach Anspruch 1, **dadurch gekennzeichnet, dass** der Zwischenraum (3) als optisches Medium eine Klebeschicht (32) enthält.

3. Sensoranordnung nach Anspruch 1, **dadurch gekennzeichnet, dass** der Zwischenraum (3) als optisches Medium eine Luftschicht (33) enthält, die von Klebstoff (31) wenigstens teilweise umschlossen ist.

4. Sensoranordnung nach Anspruch 1, **dadurch gekennzeichnet, dass** die Verkippung so eingestellt ist, dass durch Wahl einer bestimmten Anzahl (x) von Überlagerungsperioden Interferenzrippel verschiedener Frequenzen vorhanden sind, die sich durchmischend überlagern und kompensieren.

5. Sensoranordnung nach Anspruch 4, **dadurch gekennzeichnet, dass** die Höhenvariation ($\Delta$h) für eine optimale Verkippung gemäß der Gleichung

$$\text{i. } \Delta h = x \bullet \lambda, /(2n_2)$$

eingestellt ist.

## Claims

1. Sensor arrangement for colour measurement with interference ripple suppression containing at least one silicon-based optical sensor having at least three separate light-sensitive sensor faces and a sensor passivation, which is composed of a combination of SiO$_2$ layer (12) and anti-reflection-adapted Si$_3$N$_4$ layer (13), **characterised in that**

- the SiO$_2$ layer (12) has a thickness in the range from 5 to 10 nm,
- above the sensor passivation, there is arranged a substrate (2) which carries at least three spectrally different interference filters (21; 23, 24, 25) and which is connected to the sensor (1) by means of an adhesive (31) and which forms between each of the light-sensitive sensor faces (11) and an interference filter (21) which is associated with the respective sensor face (11) an intermediate space (3) in the manner of an optical layer (32; 33) with a lower refractive index (n$_2$) with respect to the sensor passivation of the sensor (1), and
- the optical layer (32; 33) over each associated light-sensitive sensor face (11) has a height variation ($\Delta$h), wherein the height variation ($\Delta$h) is produced by means of a tilting of the substrate (2) with the optical filters (21; 23, 24, 25) with respect to the light-sensitive sensor faces (11), wherein spacers (26) for defined adjustment of the substrate tilting are provided on the substrate (2) at predetermined positions which are produced in the process of the production of the optical filters (21; 23, 24, 25) by sequential coating of filters (21; 23, 24, 25) of known layer thicknesses at a defined height.

2. Sensor arrangement according to claim 1, **characterised in that** the intermediate space (3) contains an adhesive layer (32) as an optical medium.

3. Sensor arrangement according to claim 1, **characterised in that** the intermediate space (3) contains as an optical medium an air layer (33) which is at least partially surrounded by adhesive (31).

4. Sensor arrangement according to claim 1, **characterised in that** the tilting is adjusted in such a manner that, by selecting a specific number (x) of overlap periods, interference ripples of different frequencies which overlap each other and compensate for each other by being blended together are provided.

5. Sensor arrangement according to claim 4, **characterised in that** the height variation ($\Delta h$) is adjusted for an optimum tilting according to the equation:

$$\text{i.} \qquad \Delta h = x \cdot \lambda\, /(2n_2).$$

**Revendications**

1. Agencement de capteur pour une mesure de couleur avec suppression d'ondulation d'interférence, contenant au moins un capteur optique à base de silicium avec au moins trois surfaces de capteur photosensibles séparées et une passivation de capteur, qui est composée d'une combinaison d'une couche de $SiO_2$ (12) et d'une couche de $Si_3N_4$ (13) à adaptation antireflet, **caractérisé en ce que**

   - la couche de $SiO_2$ (12) présente une épaisseur dans la plage de 5 à 10 nm,
   - un substrat (2) portant au moins trois filtres d'interférence (21 ; 23, 24, 25) différents sur le plan spectral est agencé au-dessus de la passivation de capteur, qui est relié au capteur (1) au moyen d'un adhésif (31) et formant un espace intermédiaire (3) entre chacune des surfaces de capteur photosensibles (11) et un filtre d'interférence (21) associé à la surface de capteur respective (11) au sens d'une couche optique (32 ; 33) avec un indice de réfraction ($n_2$) inférieur à celui de la passivation de capteur du capteur (1), et
   - la couche optique (32 ; 33) présente une variation de hauteur ($\Delta h$) au-dessus de chaque surface de capteur photosensible associée (11), dans lequel la variation de hauteur ($\Delta h$) est réalisée par une inclinaison du substrat (2) avec les filtres optiques (21 ; 23, 24, 25) par rapport aux surfaces de capteur photosensibles (11), dans lequel des entretoises (26) sont prévues pour un réglage défini de l'inclinaison de substrat sur le substrat (2) à des positions prédéterminées qui sont générées lors du processus de production des filtres optiques (21 ; 23, 24, 25) par applications successives de filtres (21 ; 23, 24, 25) d'épaisseurs de couche connues à une hauteur définie.

2. Agencement de capteur selon la revendication 1, **caractérisé en ce que** l'espace intermédiaire (3) contient une couche adhésive (32) en tant que milieu optique.

3. Agencement de capteur selon la revendication 1, **caractérisé en ce que** l'espace intermédiaire (3) contient une couche d'air (33) comme milieu optique, qui est au moins partiellement entourée par de l'adhésif (31).

4. Agencement de capteur selon la revendication 1, **caractérisé en ce que** l'inclinaison est réglée de telle sorte que, par une sélection d'un nombre déterminé (x) de périodes de superposition, des ondulations d'interférence de fréquences différentes sont présentes, qui se superposent et se compensent les unes les autres de manière mixte.

5. Agencement de capteur selon la revendication 4, **caractérisé en ce que** la variation de hauteur ($\Delta h$) est réglée pour une inclinaison optimale selon l'équation :

$$\text{i.} \qquad \Delta h = x \cdot \lambda\, /(2n_2).$$

**Fig. 1**

# Fig. 2

# Fig. 3

**Fig. 4**

**Fig. 5a**

**Fig. 5b**

Fig. 6a

Fig. 6b

**Fig. 7**

Fig. 8

EP 2 803 959 B1

# Fig. 9a

# Fig. 9b

Oberseite der Sensoranordnung

Fig. 10

**IN DER BESCHREIBUNG AUFGEFÜHRTE DOKUMENTE**

**In der Beschreibung aufgeführte Patentdokumente**

- US 7626241 B1
- JP 5316284 A
- US 2010026866 A1
- EP 2009696 A2
- US 7330266 B
- US 7626241 B
- US 2008278665 A